# EUROPEAN PATENT APPLICATION

(11) **EP 1 482 367 A2**
(43) Date of publication of application: **01.12.2004**
(21) Application number: 04012133.7
(22) Date of filing: 21.05.2004
(51) Int. Cl.: G03F 7/20

(54) **System and method for producing gray scaling using multiple spatial light modulators in a maskless lithography system**

(30) Priority: 29.05.2003 US 447197
(71) Applicant: ASML Holding N.V., 5504 DR Veldhoven (NL)
(72) Inventor: Wasserman, Solomon S., Long Beach New York 11561 (US); Cebuhar, Wenceslao A., Norwalk Connecticut 06851 (US); Hintersteiner, Jason D., Bethel Connecticut 06801 (US); Volpe, Gerald T., Stamford Connecticut 06902 (US)
(74) Representative: Grünecker, Kinkeldey, Stockmair & Schwanhäusser Anwaltssozietät

(57) **Abstract**

A maskless lithography system and method produces gray scale patterns on objects. The system includes an illumination source (e.g., either pulsed or effectively continuous), an object including an array of exposure areas, an array of spatial light modulators (e.g., either digital, binary, or analog), and a controller. The array of spatial light modulators pattern and direct light from the illumination source to the object. Each of the spatial light modulators have active areas that respectively correspond with one of the exposure areas on the object. The controller controls the array of spatial light modulators, such that the pattern of the light has spatially varying intensities.

## Description

### BACKGROUND OF THE INVENTION

### Field of the Invention

The present invention relates generally to lithography. More particularly, the present invention relates to maskless lithography.

### Related Art

Lithography is a process used to create features on the surface of substrates. Such substrates can include those used in the manufacture of flat panel displays (e.g., liquid crystal displays), circuit boards, various integrated circuits, and the like. A frequently used substrate for such applications is a semiconductor wafer or glass substrate. While this description is written in terms of a semiconductor wafer for illustrative purposes, one skilled in the art would recognize that this description also applies to other types of substrates known to those skilled in the art.

During lithography, a wafer, which is disposed on a wafer stage, is exposed to an image projected onto the surface of the wafer by exposure optics located within a lithography apparatus. While exposure optics are used in the case of photolithography, a different type of exposure apparatus can be used depending on the particular application. For example, x-ray, ion, electron, or photon lithography each can require a different exposure apparatus, as is known to those skilled in the art. The particular example of photolithography is discussed here for illustrative purposes only.

The projected image produces changes in the characteristics of a layer, for example photoresist, deposited on the surface of the wafer. These changes correspond to the features projected onto the wafer during exposure. Subsequent to exposure, the layer can be etched to produce a patterned layer. The pattern corresponds to those features projected onto the wafer during exposure. This patterned layer is then used to remove or further process exposed portions of underlying structural layers within the wafer, such as conductive, semiconductive, or insulative layers. This process is then repeated, together with other steps, until the desired features have been formed on the surface, or in various layers, of the wafer.

Step-and-scan technology works in conjunction with a projection optics system that has a narrow imaging slot. Rather than expose the entire wafer at one time, individual fields are scanned onto the wafer one at a time. This is accomplished by moving the wafer and reticle simultaneously such that the imaging slot is moved across the field during the scan. The wafer stage must then be asynchronously stepped between field exposures to allow multiple copies of the reticle pattern to be exposed over the wafer surface. In this manner, the quality of the image projected onto the wafer is maximized.

Conventional lithographic systems and methods form images on a semiconductor wafer. The system typically has a lithographic chamber that is designed to contain an apparatus that performs the process of image formation on the semiconductor wafer. The chamber can be designed to have different gas mixtures and/or grades of vacuum depending on the wavelength of light being used. A reticle is positioned inside the chamber. A beam of light is passed from an illumination source (located outside the system) through an optical system, an image outline on the reticle, and a second optical system before interacting with a semiconductor wafer.

A plurality of reticles is required to fabricate a device on the substrate. These reticles are becoming increasingly costly and time consuming to manufacture due to the feature sizes and the exacting tolerances required for small feature sizes. Also, a reticle can only be used for a certain period of time before being worn out. Further costs are routinely incurred if a reticle is not within a certain tolerance or when the reticle is damaged. Thus, the manufacture of wafers using reticles is becoming increasingly, and possibly prohibitively, expensive.

In order to overcome these drawbacks, maskless (e.g., direct write, digital, etc.) lithography systems have been developed. The maskless system replaces a reticle with a spatial light modulator (SLM) (e.g., a digital micromirror device (DMD), a liquid crystal display (LCD), or the like). The SLM includes an array of active areas (e.g., mirrors or transmissive areas) that are either ON or OFF to form a desired pattern. A predetermined and previously stored algorithm based on a desired exposure pattern is used to turn ON and OFF the active areas.

Conventional SLM-based writing systems (e.g., Micronic's Sigma 7000 series tools) use one SLM as the pattern generator. To achieve linewidth and line placement specifications, gray scaling is used. For analog SLMs, gray scaling is achieved by controlling mirror tilt angle (e.g., Micronic SLM) or polarization angle (e.g., LCD). For digital SLMs (e.g., TI DMD), gray scaling is achieved by numerous passes or pulses, where for each pass or pulse the pixel can be switched either ON or OFF depending on the level of gray desired. Because of the total area on the substrate to be printed, the spacing between active areas, the timing of light pulses, and the movement of the substrate, several passes of the substrate are required to expose all desired areas. This results in low throughput (number of pixels packed into an individual optical field / number of repeat passes required over the substrate) and increased time to fabricate devices. Furthermore, using only one SLM requires more pulses of light or more exposure time to increase gray scale. This can lead to unacceptably low levels of throughput.

Therefore, what is needed is a maskless lithography system and method with an increased gray scale ability using a relatively low amount of pulses (e.g., 2 to 4 pulses) per feature.

### SUMMARY OF THE INVENTION

The present invention provides a method for producing gray scale patterns on objects during maskless lithography. The method includes illuminating light onto an array of spatial light modulators (SLMs), patterning the light with the SLMs to produce an exposure light pattern having spatially varying intensities, and writing the patterned light onto the object to produce the gray scaled patterns on the object based on the spatially varying light intensities.

The present invention also provides a maskless lithography system for producing gray scale patterns on objects. The system includes an illumination source, an object including an array of exposure areas, an array of spatial light modulators, and a controller. The array of spatial light modulators pattern and direct light from the illumination source to the object. Each of the spatial light modulators have active areas that respectively correspond with one of the exposure areas on the object. The controller controls the array of spatial light modulators, such that the pattern of the light has spatially varying intensities.

Further embodiments, features, and advantages of the present inventions, as well as the structure and operation of the various embodiments of the present invention, are described in detail below with reference to the accompanying drawings.

### BRIEF DESCRIPTION OF THE DRAWINGS/FIGURES

The accompanying drawings, which are incorporated herein and form a part of the specification, illustrate the present invention and, together with the description, further serve to explain the principles of the invention and to enable a person skilled in the pertinent art to make and use the invention.

FIG. 1 shows a maskless lithography system having reflective spatial light modulators according to embodiments of the present invention

FIG. 2 shows a maskless lithography system having transmissive spatial light modulators according to embodiments of the present invention.

FIG. 3 shows a spatial light modulator according to an embodiment of the present invention.

FIG. 4 shows more details of the spatial light modulator in FIG. 3.

FIG. 5 shows an assembly according to an embodiment of the present invention.

FIG. 6 shows a portion of either a maskless lithography system when a continuous light source is used according to an embodiment of the present invention.

FIG. 7 shows a correlation between active areas on SLMs and exposure areas on an object according to an embodiment of the present invention

FIG. 8 shows a flow chart depicting a method 800 according to embodiments of the present invention.

The present invention will now be described with reference to the accompanying drawings. In the drawings, like reference numbers may indicate identical or functionally similar elements. Additionally, the left-most digit(s) of a reference number may identify the drawing in which the reference number first appears.

### DETAILED DESCRIPTION OF THE INVENTION

### Overview

While specific configurations and arrangements are discussed, it should be understood that this is done for illustrative purposes only. A person skilled in the pertinent art will recognize that other configurations and arrangements can be used without departing from the spirit and scope of the present invention. It will be apparent to a person skilled in the pertinent art that this invention can also be employed in a variety of other applications.

The present invention provides a maskless lithography system and method for producing gray scale patterns on objects. The system includes an illumination source (e.g., either pulsed or effectively continuous), an object including an array of exposure areas, an array of spatial light modulators (e.g., either digital, binary, or analog), and a controller. The array of spatial light modulators pattern and direct light from the illumination source to the object. Each of the spatial light modulators have active areas that respectively correspond with one of the exposure areas on the object. The controller controls the array of spatial light modulators, such that the pattern of the light has spatially varying intensities.

### Maskless Lithography Systems

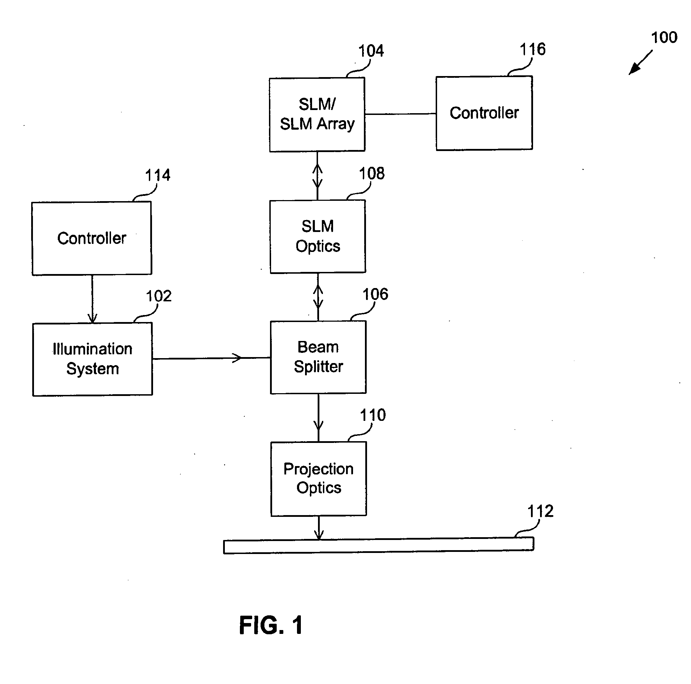

FIG. 1 shows a maskless lithography system 100 according to an embodiment of the present invention. System 100 includes an illumination system 102 that transmits light to a reflective spatial light modulator 104 (e.g., a digital micromirror device (DMD), a reflective liquid crystal display (LCD), or the like) via a beam splitter 106 and SLM optics 108. SLM 104 is used to pattern the light in place of a reticle in traditional lithography systems. Patterned light reflected from SLM 104 is passed through beam splitter 106 and projection optics 110 and written on an object 112 (e.g., a substrate, a semiconductor wafer, a glass substrate for a flat panel display, or the like).

It is to be appreciated that illumination optics can be housed within illumination system 102, as is known in the relevant art. It is also to be appreciated that SLM optics 108 and projection optics 110 can include any combination of optical elements required to direct light onto desired areas of SLM 104 and/or object 112, as is known in the relevant art.

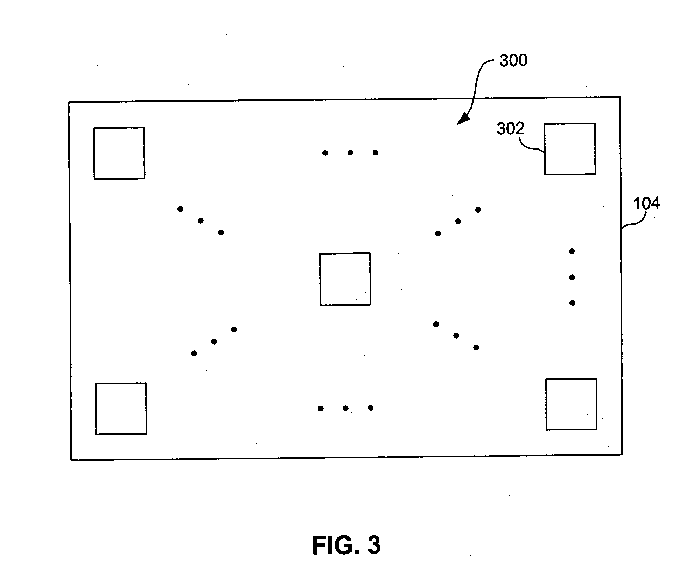

In alternative embodiments, either one or both of illumination system 102 and SLM 104 can be coupled to or have integral controllers 114 and 116, respectively. Controller 114 can be used to adjust illumination source 102 based on feedback from system 100 or to perform calibration. Controller 116 can also be used for adjustment and/or calibration. Alternatively, controller 116 can be used for turning ON and OFF active devices 302 (e.g., pixels, mirrors, locations, etc.) (see FIG. 3) on SLM 104, as was described above, to generate a pattern used to expose object 112. Controller 116 can either have integral storage or be coupled to a storage element (not shown) with predetermined information and/or algorithms used to generate the pattern or patterns.

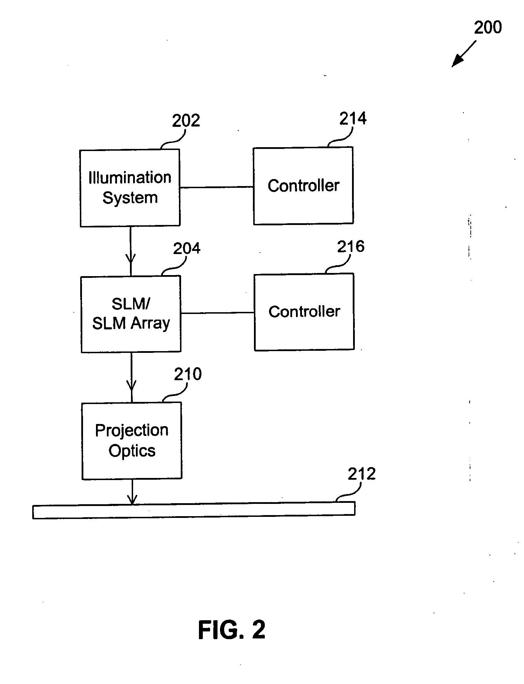

FIG. 2 shows a maskless lithography system 200 according to a further embodiment of the present invention. System 200 includes an illumination source 202 that transmits light through a SLM 204 (e.g., a transmissive LCD, or the like) to pattern the light. The patterned light is transmitted through projection optics 210 to write the pattern on a surface of an object 212. In this embodiment, SLM 204 is a transmissive SLM, such as a liquid crystal display, or the like. Similar to above, either one or both of illumination source 202 and SLM 204 can be coupled to or integral with controllers 214 and 216, respectively. Controllers 214 and 216 can perform similar functions as controller 114 and 116 described above, and as known in the art.

Example SLMs that can be used in systems 100 or 200 are manufactured by Micronic Laser Systems AB of Sweden, Texas Instruments of Texas, USA, and Fraunhofer Institute for Circuits and Systems of Germany.

Merely for convenience, reference will be made only to system 100 below. However, all concepts discussed below can also apply to system 200, as would be known to someone skilled in the relevant arts.

FIG. 3 shows details of an active area 300 of SLM 104. Active area 300 includes an array of active devices 302 (represented by dotted patterns in the figure). Active devices 302 can be mirrors on a DMD or locations on a LCD. It is to be appreciated that active devices 302 can also be referred to as pixels, as is known in the relevant art. By adjusting the physical characteristics of active devices 302, they can be seen as being either ON or OFF. Digital or analog input signals based on a desired pattern are used to turn ON and OFF various active devices 302. In some embodiments, an actual pattern being written to object 112 can be detected and a determination can be made whether the pattern is outside an acceptable tolerance. If so, controller 116 can be used to generate analog or digital control signals in real time to fine-tune (e.g., calibrate, adjust, etc.) the pattern being generated by SLM 104.

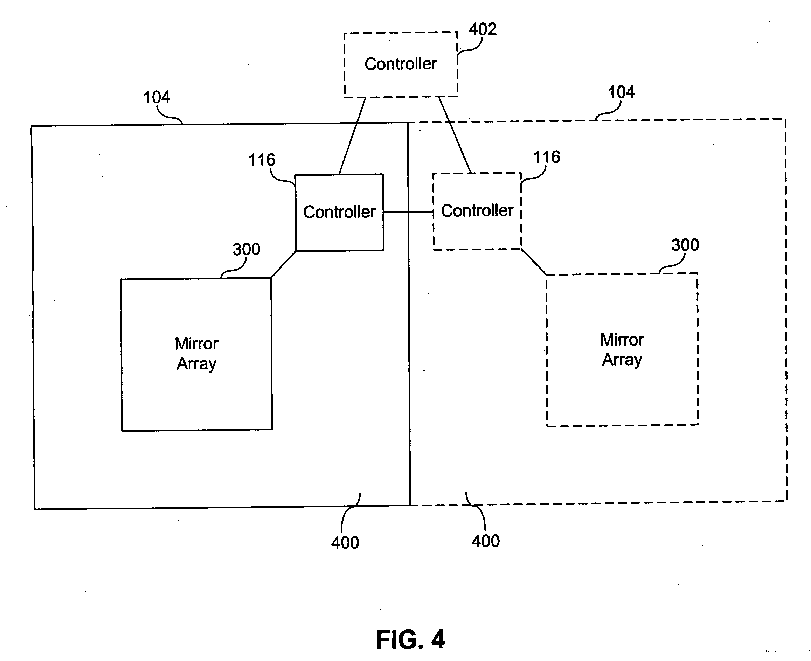

FIG. 4 shows further details of SLM 104. SLM 104 can include an inactive packaging 400 surrounding active area 300. Also, in alternative embodiments, a main controller 402 can be coupled to each SLM controller 116 to monitor and control an array of SLMs (see discussion below). As discussed below, adjacent SLMs may be offset or staggered with respect to each other in other embodiments.

### Spatial Light Modulator Array Configuration

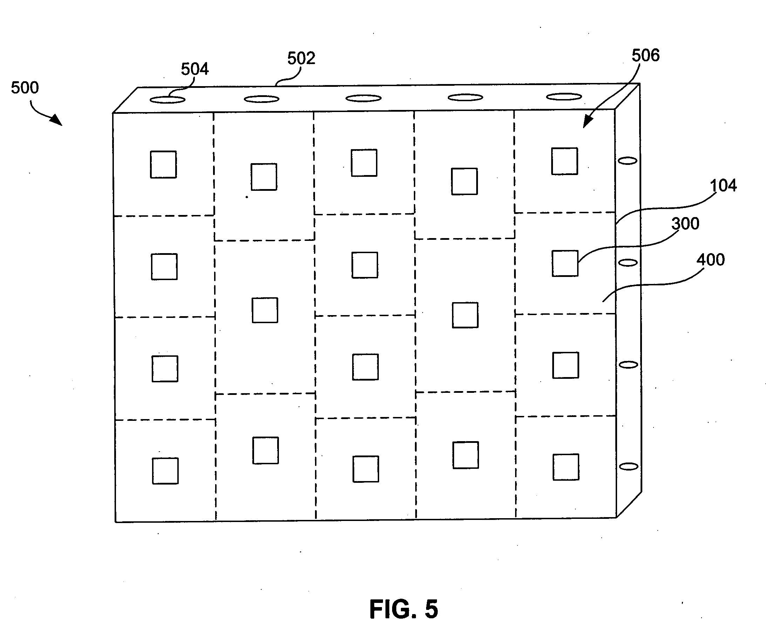

FIG. 5 shows an assembly 500 including a support device 502 that receives an array of SLMs 104. In various embodiments, as described in more detail below, the array of SLMs 104 can have varying numbers of columns, rows, SLMs per column, SLMs per row, etc., based on a number of desired exposures per pulse, or other criteria of a user. The SLMs 104 can be coupled to a support device 502. Support device 502 can have thermal control areas 504 (e.g., water or air channels, etc.), areas for control logic and related circuitry (e.g., see FIG. 4 showing elements 116 and element 402, which can be ASICs, A/D converters, D/A converters, fiber optics for streaming data, etc.), and windows 506 (formed within the dashed shapes) that receive SLMs 104, as is known in the relevant art. Support device 502, SLMs 104, and all peripheral cooling or control devices are referred to as an assembly. Assembly 500 can allow for a desired step size to produce the desired stitching (e.g., connecting of adjacent elements of features on object 112) and overlap for leading and trailing SLMs 104. By way of example, support device 502 can be 250 mm x 250 mm (12 in x 12 in) or 300 mm x 300 mm (10 in x 10 in). Support device 502 can be used for thermal management based on being manufactured from a temperature stable material.

Support device 502 can be utilized as a mechanical backbone to ensure spacing control of SLMs 104 and for embedding the circuitry and the thermal controls areas 504. Any electronics can be mounted on either or both of a backside and front side of support device 502. For example, when using analog based SLMs or electronics, wires can be coupled from control or coupling systems 504 to active areas 300. Based on being mounted on support device 502, these wires can be relatively shorter, which reduces attenuation of analog signals compared to a case where the circuitry is remote from the support device 502. Also, having short links between the circuitry and active areas 300 can increase communication speed, and thus increase pattern readjustment speed in real time.

In some embodiments, when SLM 104 or electrical devices in the circuitry wear out, assembly 500 can easily be replaced. Although it would appear replacing assembly 500 is more costly than just a chip on assembly 500, it is in fact easier and quicker to replace the entire assembly 500, which can save production costs. Also, assembly 500 can be refurbished, allowing for a reduction in replacement parts if end users are willing to use refurbished assemblies 500. Once assembly 500 is replaced, only an overall alignment is needed before resuming fabrication.

The present invention provides for gray scaling of patterned areas on an object using a maskless lithography system. The gray scaling is based on using an array of spatial light modulators (SLMs). Each exposure area on the object correlates to one active area on each of the SLMs. Thus, each exposure area is written to, or not written to as the case may be, by each SLM. Thus, a level of gray scaling is determined by the number of SLMs used in the array. An illumination system can include either a pulsed light source or an equivalent substantially continuous light source.

### Time-Modulated Gray Scaling

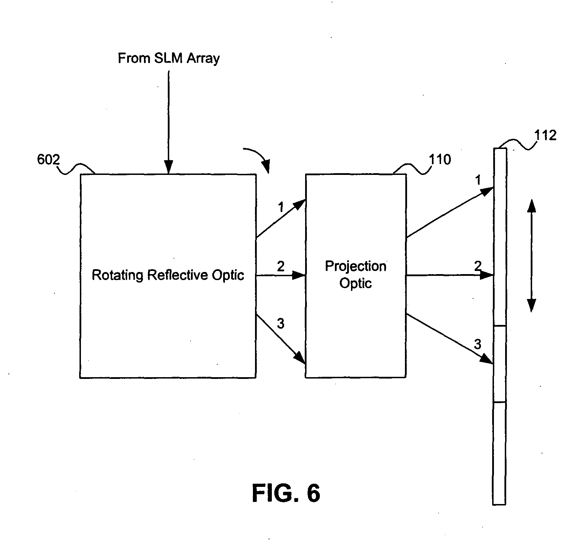

FIG. 6 shows a portion 600 of either system 100 or 200 when a continuous light source is used. Portion 600 includes a rotating optical element 602 (e.g., a prism, or a circular, spherical, or conical optical reflecting element, or the like), which can rotate in any direction, positioned between SLMs 104 and projection optics 110. Arrows numbered 1, 2, and 3 show a possible light beam direction leaving rotating element 602 and, in turn, projection optic 110, based on a scanning position of object 112, as is discussed in more detail below. This system can use either a digital SLM or an analog SLM, which is discussed below.

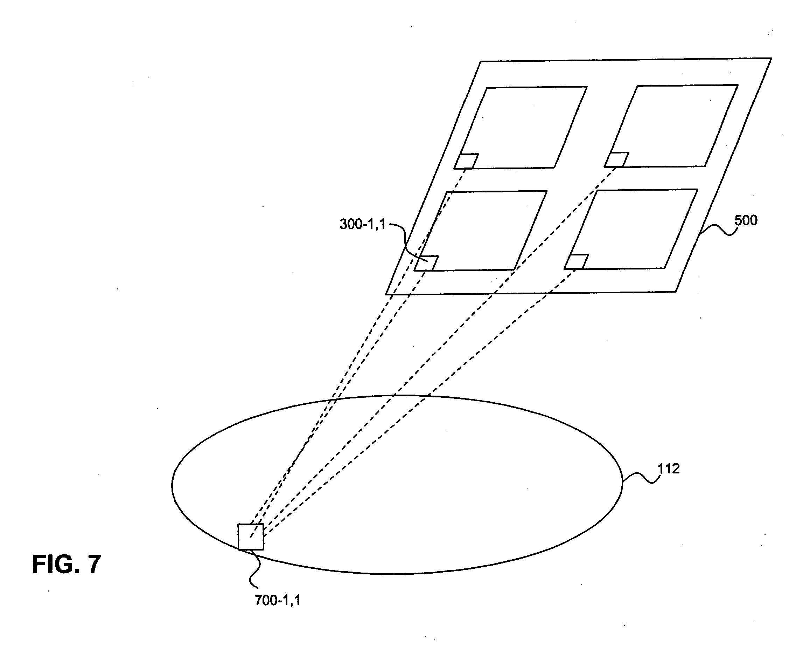

FIG. 7 shows a correlation between active areas 300 on SLMs 104 and exposure areas 700 on object 112. Basically, each exposure area 700 can be assigned an X,Y coordinate (e.g., exposure area 700-1,1) that corresponds to one active area 300 (e.g., 300-1,1) on all SLMs 104. So, depending on whether active area 300 is ON or OFF, light is written or not written from 300-1,1 of each SLM to exposure area 700-1,1.

It is to be appreciated that active areas 300 and exposure areas 700 can also be referred to as pixels, as is known in the relevant arts.

There can be at least two configurations and methods that can be used to produce gray scaling on object 112 in maskless lithography without substantially increasing the pulses required and/or the amount of exposure time per exposed area on object 112 beyond an optimum time amount. This will keep throughput relatively high. A first embodiment uses a pulsed light source and a second embodiment uses a continuous light source, or the equivalent thereof.

In the first embodiment, a pulsed light source (not shown) (operating, for example, at 1 Khz to 4 Khz) can be used in illuminating system 102. Alternatively, a bank of parallel pulsed light sources that are slightly out of synch with one anther can be used to increase an effective rep rate from illuminating system 102. Each SLM 104 has an array of active areas 300, where each active area is correlated to a particular exposure area on object 112 (e.g., using an X,Y coordinate grid on object 112 correlated to an X,Y coordinate grid on each SLM 104). The pulsed light signals are directed to SLMs 104. Based on the pattern received by SLMs 104 from controller 116, a light pattern is generated with spatially varying light intensities. The varying light intensities are based on how many of the similarly positioned active areas 300 across the SLM array 500 are turned ON or OFF for that particular time period. For example, if an SLM array has the equivalent of 32 active areas, then 32 levels of gray scaling can result. In this example, all 32 can be ON, all 32 can be OFF, or some mixture of the 32 can be ON or OFF, which produces 32 levels of gray. Thus, an exposure area correlated to the same active area 300 on each SLM 104 can receive light from all SLMs 104, none of the SLMs 104, or some mixture of the SLMs 104 for each pulse of light. In another example, if two pulses of light are normally used for each exposure area, then 64 levels of gray scale will result. In still further examples, 128, 256, etc. levels of gray scale can be achieved.

It is to be appreciated that similar results to those discussed above can be achieved with analog SLMs. The intermediate gray scale level settings achieved by the SLM on each pulse can be used in combination over multiple SLMs and/or multiple pulses to achieve a finer resolution of gray. Thus, this can enhance the number of gray scale levels that are already available mechanically.

In the second embodiment, a continuous or equivalently/effectively (hereinafter, equivalently or effectively will be referred to as "effectively") continuous light source (not shown) can be used. Effectively continuous means that a frequency of the light source is greater than a reaction time of active areas 300, which makes the light source look continuous to active areas 300. For example, a digital SLM 104 can update at about 50 Khz, so that when using a light source at about 100 Khz the light source appears continuous to SLM 104. As another example, an analog SLM can update at about 4 kHz, so most light sources operating substantially significantly above about 4 kHz can be considered effectively continuous light sources. Other types may also be considered within the scope of the invention. When using a continuous light source, rotating optics 602 would most likely be used to produce a moving image from the patterned light. Thus, as object 112 is moving the image is moving. To do this, as object 112 is moving, rotating optics 602 is rotated synchronously, tracking the movement of object 112. This allows system 100 to print each active area pattern on object 112 at a particular exposure area. So, if object 112 is continuously moving, rotating optics 602 are used to move the image. As in the embodiment discussed above, the same active area 300 from each SLM 104 will print the pattern from that active area 300 to the particular exposure area on object 112. In this embodiment, gray scale is based on time as the moving pixel cycles on or off.

In another embodiment, an analog SLM 104 can be used that has varying levels of light intensity leaving each active area 300. This analog SLM 104 can be used in the effectively continuous illumination system, as described above.

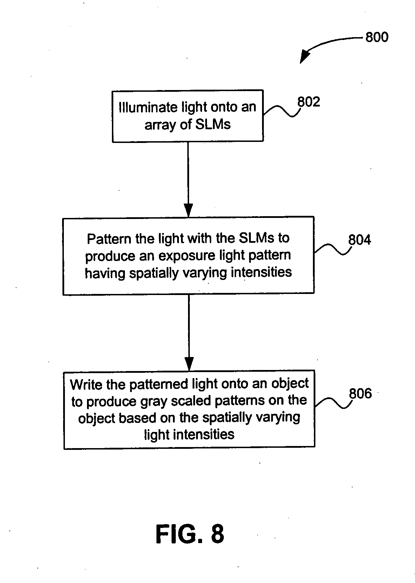

FIG. 8 shows a flow chart depicting a method 800 according to the present invention. In step 802, light is illuminated onto an array of SLMs. In step 804, the light is patterned with the SLMs to produce an exposure light pattern having spatially varying intensities. In step 806, the patterned light is written onto an object to produce gray scaled patterns on the object based on the spatially varying light intensities.

Thus, for digital SLMs the above methods and system allow for increase gray scale levels without increasing a conventional number of passes and/or pulses than conventionally done. Also, for analog SLMs, the above methods and systems allow for enhancing a number of gray scale levels beyond what is already mechanically feasible without increasing a conventional number of passes or pulses.

### Conclusion

While various embodiments of the present invention have been described above, it should be understood that they have been presented by way of example only, and not limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the following claims and their equivalents.

## Claims

1. A method for producing gray scale patterns on objects during maskless lithography, comprising:
illuminating light onto an array of spatial light modulators (SLMs);
patterning the light with the SLMs to produce an exposure light pattern having spatially varying intensities; and
writing the patterned light onto the object to produce the gray scaled patterns on the object based on the spatially varying light intensities.

2. The method of claim 1, wherein the illumination comprises pulsed illumination.

3. The method of claim 1, wherein the illumination is equivalent to a substantially continuous illumination.

4. The method of claim 1, wherein the object comprises an array of pattern areas and wherein each of the SLMs contains active areas that correspond to respective ones of the pattern areas.

5. The method of claim 4, wherein the spatially varying intensities are produced by controlling light directing properties of the active areas.

6. The method of claim 4, wherein each active area is either ON or OFF and the gray scale pattern is based on how many of a same respective ones of the active areas on individual ones of the SLMs are ON and OFF at substantially the same time.

7. The method of claim 4, further comprising reflecting the light from the active areas toward the object when the active areas are ON and reflecting the light from the active areas away from the object when the active areas are OFF.

8. The method of claim 4, further comprising transmitting the light through the active areas when they are ON and reflecting the light from the active areas when they are OFF.

9. The method of claim 4, further comprising producing a gray scale pattern that comprises 32 levels of gray.

10. The method of claim 4, wherein the illumination comprises substantially continuous illumination and wherein a rotating optical element reflects the patterned light onto the object.

11. A maskless lithography system for producing gray scale patterns on objects, comprising:
an illumination source;
an object including an array of exposure areas;
an array of spatial light modulators that pattern and direct light from the illumination source to the object, each of the spatial light modulators having active areas that respectively correspond to one of the exposure areas on the object; and
a controller that controls the array of spatial light modulators, such that the pattern of the light has spatially varying intensities.

12. The system of claim 11, wherein the illumination source is a pulsed illumination source.

13. The system of claim 11, wherein the illumination source is equivalent to a substantially continuous illumination source.

14. The system of claim 13, further comprising:
a rotating optical element that reflects the light from the SLMs to the object.

15. The system of claim 11, wherein each of the active areas is turned ON or OFF by the controller.

16. The system of claim 15, wherein:
light reflects from the active areas to the object when the active areas are turned ON; and
light reflects from the active areas away from the object when the active areas are turned OFF.

17. The system of claim 15, wherein:
light is transmitted through the active areas to the object when the active areas are turned ON; and
light is reflected from the active areas away from the object when the active areas are turned OFF.

18. The system of claim 15, wherein the varying intensities are based on how many of the active areas correlating to a specific one of the exposure areas are turned ON and OFF.

19. The system of claim 15, wherein:
the illumination system produces pulsed light signals, and
the varying intensities are generated by the active areas being turned ON or OFF, which produces gray scaling at the exposure area for each one of the pulsed light signals.

20. The system of claim 15, further comprising:
a rotating optical element that directs light from the SLMs to the object, wherein the illumination system produces an effectively substantially continuous light signal that produces gray scaling at the exposure area based the light reflecting from the rotating optical element.

21. The method of claim 3, wherein the effectively continuous light source operates at a frequency above a SLM refresh rate.

22. The method of claim 3, wherein the effectively continuous light source operates at a frequency above about 4 kHz.

23. The system of claim 13, wherein the effectively continuous light source operates at a frequency above a SLM refresh rate.

24. The system of claim 13, wherein the effectively continuous light source operates at a frequency above about 4 kHz.

25. The method of claim 1, further comprising providing digital SLMs as the SLMs.

26. The method of claim 1, further comprising providing binary SLMS as the SLMs.

27. The method of claim 1, further comprising providing analog SLMS as the SLMs.

28. The method of claim 11, further comprising providing digital SLMS as the SLMs.

29. The method of claim 11, further comprising providing binary SLMS as the SLMs.

30. The method of claim 11, further comprising providing analog SLMS as the SLMs.

31. The method of claim 4, further comprising producing a gray scale pattern that comprises 64 levels of gray.

32. The method of claim 4, further comprising producing a gray scale pattern that comprises 128 levels of gray.

33. The method of claim 4, further comprising producing a gray scale pattern that comprises 256 levels of gray.

34. The system of claim 27, wherein a number of gray scale levels is increased.

35. The method of claim 30, further comprising using the analog SLMs to increase a number of gray scale levels.
